# EUROPEAN PATENT APPLICATION

(11) **EP 4 394 504 A1**
(43) Date of publication of application: **03.07.2024**
(21) Application number: 22217389.0
(22) Date of filing: 30.12.2022
(51) Int. Cl.: G03F 7/00, H01L 21/683, H01L 21/687

(54) **OBJECT HOLDER**

(71) Applicant: ASML Netherlands B.V., 5500 AH Veldhoven (NL)
(72) Inventor: SCHMIDT, Volker, 5500 AH Veldhoven (NL)
(74) Representative: ASML Netherlands B.V.

(57) **Abstract**

An object holder configured to support an object, the object holder comprising a first conductive layer provided between a first insulating layer and a second insulating layer, a second conductive layer provided between the second insulating layer and a third insulating layer, a plurality of burls, each burl of the plurality of burls comprising an object receiving surface and a layer of resistive or conductive material provided on at least one or each burl of the plurality of burls such that the layer of resistive or conductive material electrically connects the object receiving surface of the at least one or each burl of the plurality of burls to the first conductive layer.

## Description

### FIELD

The present invention relates to an object holder and a method of manufacturing the object holder. The object holder may be part of an object table of a lithographic apparatus or lithographic tool.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

The substrate to be exposed may be supported by a substrate holder (i.e. the object that directly supports a substrate), which in turn is supported by a substrate table. The substrate holder may have an array of projections, referred to as burls, projecting from at least one side. When the substrate rests on the top of the burls on the at least one side of the substrate holder, the substrate may be spaced apart from a main body of the substrate holder. This may aid in the prevention of a particle (i.e. a contaminating particle such as a dust particle), which may be present on the substrate holder, from distorting the substrate holder or substrate. The total surface area of the burls may only be a small fraction of the total area of the substrate or substrate holder. As such, it is more probable that any particle will lie between burls and its presence will have no effect.

Due to the high accelerations that may be experienced by the substrate in use of a high-throughput lithographic apparatus, it may not be sufficient to allow the substrate simply to rest on the burls of the substrate holder. It is clamped in place. Two methods of clamping the substrate in place may be used - vacuum clamping and electrostatic clamping. In vacuum clamping, the space between the substrate holder and substrate and optionally between the substrate table and substrate holder are partially evacuated so that the substrate is held in place by the higher pressure of gas or liquid above it. Vacuum clamping, however, may not be used where the beam path and/or the environment near the substrate or substrate holder is kept at a low or very low pressure, e.g. for extreme ultraviolet (EUV) radiation lithography. In this case, it may not be possible to develop a sufficiently large pressure difference across the substrate (or substrate holder) to clamp it. Electrostatic clamping may, therefore, be used. In electrostatic clamping, a potential difference is established between the substrate and the substrate table and/or substrate holder. The potential difference may generate a clamping force.

There is a need to improve a substrate holder that comprises a electrostatic clamp for clamping a substrate to the substrate holder.

### SUMMARY

According to a first aspect of the invention there is provided an object holder configured to support an object, the object holder comprising a first conductive layer provided between a first insulating layer and a second insulating layer, a second conductive layer provided between the second insulating layer and a third insulating layer, a plurality of burls, each burl of the plurality of burls comprising an object receiving surface and a layer of resistive or conductive material provided on at least one or each burl of the plurality of burls such that the layer of resistive or conductive material electrically connects the object receiving surface of the at least one or each burl of the plurality of burls to the first conductive layer.

By providing a layer of resistive or conductive material on at least one or each burl of the plurality of burls such that the layer of resistive or conductive material electrically connects the object receiving surface of the at least one or each burl of the plurality of burls to the first conductive layer, which is provided between the first insulating layer and the second insulating layer, a connection of the object receiving surface of the at least one or each burl of the plurality of burls to ground potential or a voltage source may be facilitated. For example, by connecting the object receiving surface of the at least one or each burl of the plurality of burls to ground potential, charges that may remain on the object receiving surface, e.g. after release of the object by the object holder, may be reduced.

Additionally or Alternatively, by providing the layer of resistive or conductive material on the at least one or each burl of the plurality of burls such that the layer of resistive or conductive material electrically connects the object receiving surface of the at least one or each burl of the plurality of burls to the first conductive layer, which is provided between the first insulating layer and the second insulating layer, the use of a so-called "Manhattan pattern" may be avoided. Each burl of the plurality of burls may comprise a distal end. The so-called "Manhattan pattern" may comprise a series of metal lines that connect together the distal ends of the plurality of burls to allow the distal ends of the plurality of burls to be connected to ground potential. However, the use of such pattern may reduce an effective clamping surface of an object holder. This is because this pattern may shield a part of the generated electric field that is required to clamp the object to the object holder. This pattern may also cause a so-called "Cycle-Induced-Charge-Effect", in which charge carriers may be created, e.g. at a border of the pattern. These charge carriers may remain as residual charge carriers and it may be difficult to reduce them.

The at least one or each burl of the plurality of burls may be surrounded by an annular recess. The recess may extend through the first and second conductive layers, the second and third insulating layers and at least partially into the first insulating layer. The layer of resistive or conductive material may be provided on the at least one or each burl of the plurality of burls, e.g. so as to extend from the object receiving surface of the at least one or each burl of the plurality of burls into the recess, along a part of the first insulating layer and/or to the first conductive layer.

Alternatively, the recess may extend through the second conductive layer and the second and third insulating layers, e.g. so as to expose at least a part of the first conductive layer. The layer of resistive or conductive material may be provided on the at least one or each burl of the plurality of burls, e.g. so as to extend from the object receiving surface of the at least one or each burl of the plurality of burls into the recess and/or to the first conductive layer.

The object holder may comprise at least one of: an electrostatic clamp or an electrostatic clamp and a Johnsen-Rahbek clamp.

The first conductive layer may be configured as an electrode for connecting the electrostatic clamp to ground potential, e.g. when the object holder comprises the electrostatic clamp. The first conductive layer may be configured as an electrode for connecting the Johnsen-Rahbek clamp to a voltage source, e.g. when the object holder comprises the electrostatic clamp and the Johnsen-Rahbek clamp.

The second conductive layer may be configured as two or more electrodes for connecting the electrostatic clamp to a voltage source. The two or more electrodes may be electrically isolated from each other.

The second and third insulating layers may be arranged to electrically isolate the second conductive layer from the first conductive layer and/or the layer of resistive or conductive material.

The first, second and/or third insulating layer may comprise an insulating ceramic material. The insulating ceramic material may comprise at least one of: silicon nitride and/or aluminium oxide.

The first conductive layer may comprise an electrically conducting material. The electrically conducting material may comprise at least one of: titanium nitride and/or molybdenum silicide. The electrically conducting material may comprise a conductive ceramic material, such as doped silicon nitride. For example, the electrically conducting material may comprise silicon nitride doped with titanium nitride and/or silicon nitride doped with molybdenum silicide.

The layer of resistive or conductive material may comprise a resistive material. The resistive material may comprise at least one of: a volume resistance of about 10¹¹ Ohm cm, aluminium nitride and/or lithium aluminoasilicate.

Alternatively, the layer of resistive or conductive material comprises an electrically conducting material. The electrically conducting material may comprise at least one of: a volume resistance of less than 1 Ohm- cm, chromium nitride and/or doped diamond.

According to a second aspect of the invention there is provided an object table comprising an object holder according to the first aspect.

According to a third aspect of the invention there is provided a lithographic apparatus comprising an illumination system, a projection system and an object table according to the second aspect.

According to a fourth aspect of the invention there is provided a lithographic tool comprising an object table according to the second aspect.

According to a fifth aspect of the invention there is provided a method of manufacturing an object holder configured to support an object, the method comprising forming a first conductive layer between a first insulating layer and a second insulating layer, forming a second conductive layer between the second insulating layer and a third insulating layer, forming a plurality of burls, each burl of the plurality of burls comprising an object receiving surface and providing a layer of resistive or conductive material on at least one or each burl of the plurality of burls such that the layer of resistive or conductive material electrically connects the object receiving surface of the at least one or each burl of the plurality of burls to the first conductive layer. The object holder may comprise the object holder according to the first aspect.

Various aspects and features of the invention set out above or below may be combined with various other aspects and features of the invention as will be readily apparent to the skilled person.

### BRIEF DESCRIPTION OF THE DRAWINGS

Embodiments of the invention will now be described, by way of example only, with reference to the accompanying schematic drawings, in which:
- **Figure 1** depicts a lithographic system comprising a lithographic apparatus and a radiation source;
- **Figure 2** schematically depicts in cross section a part of an exemplary object holder for use in the lithographic apparatus of Figure 1;
- **Figure 3** schematically depicts in cross section a part of another exemplary object holder for use in the lithographic apparatus shown in Figure 1;
- **Figure 4** schematically depicts in cross section a part of another exemplary object holder for use in the lithographic apparatus shown in Figure 1;
- **Figure 5** schematically depicts a plan view of an exemplary object holder for use in the lithographic apparatus shown in Figure 1; and
- **Figure 6** depicts an exemplary flow diagram outlining the steps of a method of manufacturing an object holder configured to support an object.

### DETAILED DESCRIPTION

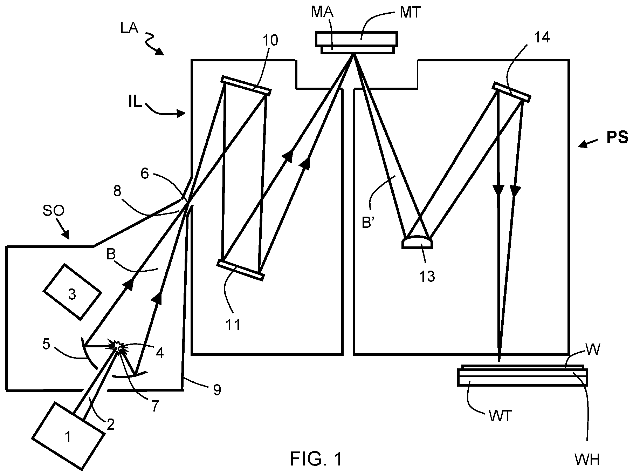

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and an object table WT. The object table WT may comprise an object holder WH configured to support an object W. The object W may be provided in the form of a substrate. The object table WT may be provided in the form of a substrate table. The object holder WH may be provided in the form of a substrate clamp. As will be described below, in some embodiments, the substrate clamp may comprise an electrostatic clamp. In other embodiments, the substrate clamp may comprise an electrostatic clamp and a Johnsen-Rahbek clamp.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during deexcitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure, which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

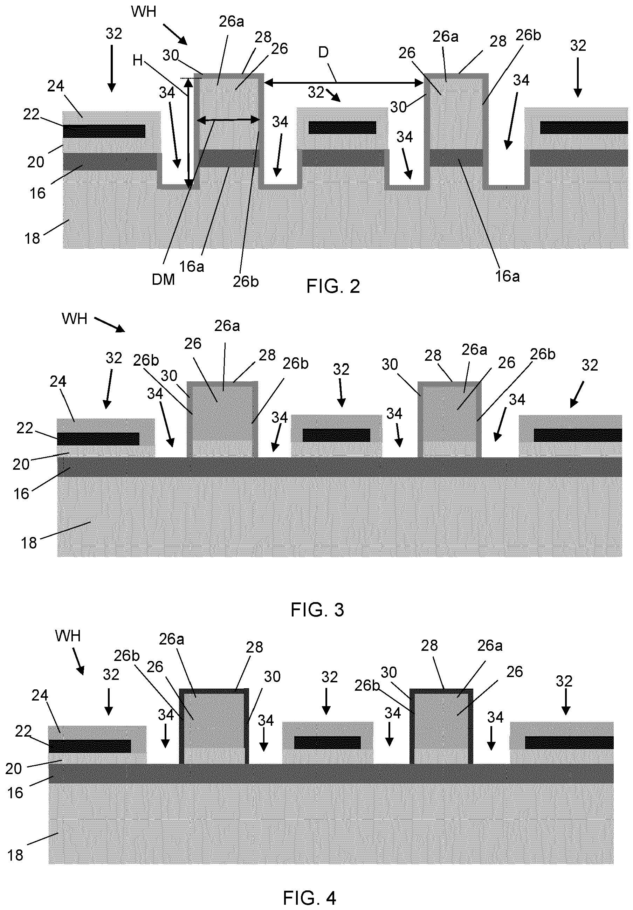

Figure 2 schematically depicts in cross section a part of an exemplary object holder WH for use in the lithographic apparatus LA shown in Figure 1. The object holder WH comprises a first conductive layer 16. The first conductive layer 16 is provided or sandwiched between a first insulating layer 18 and a second insulating layer 20. The object holder WH comprises a second conductive layer 22. The second conductive layer 22 is provided or sandwiched between the second insulating layer 20 and a third insulating layer 24. The object holder WH comprises a plurality of burls 26, two of which are shown. Each of the burls 26 may comprise an object receiving surface 28. The object holder WH comprises a layer of resistive or conductive material. In this embodiment, the layer of resistive or conductive material is referred to as a third conductive layer 30. The third conductive layer 30 is provided on each burl 26 such that the third conductive layer 30 electrically connects the object receiving surface 28 of each burl 26 to the first conductive layer 16. The third conductive layer 30 may be provided to at least partially or fully cover each burl 26. At least a part of the third conductive layer 30 may be part of, comprised in or define the object receiving surface 28 of each burl 26. It will be appreciated that in some embodiments, the third conductive layer 16 may only be provided on a few burls 26, such as one or more burls 26, while in other embodiments, the third conductive layer may be provided on all burls.

By providing the third conductive layer on each burl 26 such that the third conductive layer 30 electrically connects the object receiving surface 28 of each burl 26 to the first conductive layer 16, which is provided between the first insulating layer 18 and the second insulating layer 20, a connection of the object receiving surface 28 of each burl 26 to ground potential or a voltage source may be facilitated. For example, by connecting the object receiving surface 28 of each burl 26 to ground potential, charges that may remain on the object receiving surface 28, e.g. after release of the object W by the object holder WH, may be reduced.

By providing the third conductive layer on each burl 26 such that the third conductive layer 30 electrically connects the object receiving surface 28 of each burl 26 to the first conductive layer 16, which is provided between the first insulating layer 18 and the second insulating layer 20, the use of a so-called "Manhattan pattern" may be avoided. Such pattern may comprise a series of metal lines that connect together the distal ends of the burls to allow the distal ends of the burls to be connected to ground potential. However, the use of such pattern may reduce an effective clamping surface of an object holder. This is because this pattern may shield a part of the generated electric field that is required to clamp the object to the object holder. This pattern may also cause a so-called "Cycle-Induced-Charge-Effect", in which charge carriers may be created, e.g. at a border of the pattern. These charge carriers may remain as residual charge carriers and it may be difficult to reduce them.

As can be seen from Figure 2, the burls 26 extend or project from the first insulating layer 18. A portion 16a of the first conductive layer 16 may extend through each of the burls 26. In the embodiment shown in Figure 2, the burls extend or project upwardly from the first insulating layer 18. However, it will be appreciated that in other embodiments, the burls may additionally or alternatively extend or project downwardly from the first insulating layer and/or from another layer of the object holder. The burls 26 may define or be arranged in an array of burls 26. The burls 26 may have a cylindrical or truncated cone shape. A diameter DM of each burl 26 may be in the range of about 150 µm to 1000 µm. A height H of each burl 26 may be in the region of about 100 µm to 3000 µm. A distance D between at least two neighboring burls 26 may be in the region of about 2 mm to 3 mm. It will be appreciated that the dimensions of the burls disclosed herein are merely exemplary dimensions and that in other embodiments, the other dimensions of the burls may be used.

The object holder WH may comprise a plurality of portions 32. The portions 32 may also be referred to as flat portions. Each portion 32 comprises the first and second conductive layers 16, 22 as well as the first, second and third insulating layers 18, 20, 24. Each portion 32 of the object holder WH may be provided between at least two burls 26. The second and third insulating layers 20, 24 may be provided to electrically isolate the second conductive layer 22 from the burls 26. For example, a portion of the second conductive layer 22 that is proximal to a burl 26 may be encased by one or both of the second and third insulating layers 20, 24.

Each burl 26 may be surrounded by annular recess 34. The recess 34 may be configured to separate the burls 26 from the portions 32. For example, the recess 34 may be configured to electrically isolate each burl 26 from the second conductive layer 22. As shown in Figure 2, the recess 34 may extend through the first and second conductive layers 16, 22. The recess 34 may extend through the second and third insulating layers 20, 24 and at least partially into the first insulating layer 18. The recess 34 may extend in a direction parallel, e.g. substantially parallel, to a longitudinal direction. The third conductive layer 30 may be provided on each burl 26 so as to extend from the object receiving surface 28 into the recess 34. For example, the third conductive layer 30 may be provided on a tip 26a and a side portion 26b of each burl 26. In the embodiment shown in Figure 2, the third conductive layer 30 extends also along a part of the first insulating layer 18, e.g. in a lateral direction and the longitudinal direction, and to the first conductive layer 16, thereby electrically connecting the object receiving surface 28 of each burl to the first conductive layer 16.

In the embodiment shown in Figure 2, the object holder WH comprises an electrostatic clamp. The second conductive layer 22 may be configured as an electrode for connecting the electrostatic clamp to a voltage source (not shown in Figure 2). As will be discussed below in more detail, in this embodiment, the second conductive layer 22 is configured as two electrodes for connecting the electrostatic clamp to the voltage source. The two electrodes may be electrically isolated from each other. This may allow for voltages applied to the two electrodes to be independently and/or separately controlled. For example, voltages of opposite pluralities may be applied to the two electrodes. The electrostatic clamp may be implemented as a bipolar electrostatic clamp. It will be appreciated that in other embodiments, the second conductive layer may be configured as more than two electrodes, e.g. to form a multipolar electrostatic clamp.

The first conductive layer 16 may be configured as an electrode for connecting the electrostatic clamp to ground potential. This may allow for shielding of the burls 26 from an electric field generated by the electrostatic clamp, e.g. in use, and/or a reduction in charges that may remain on the object receiving surface 28, e.g. after release of the object W by the object holder WH.

The first, second and third insulating layers 18, 20, 24 may comprise an insulating ceramic material. For example, the insulating ceramic material may comprise at least one of silicon nitride (SiN) and/or aluminium oxide (Al₂O₃). The use of an insulating ceramic material may allow for the provision of the first and/or second conductive layers directly between the first and second insulating layers and/or the second and third insulating layer, respectively. This may facilitate the manufacture of the object holder, which in turn may lead to decreased manufacturing costs and time.

Additionally or alternatively, silicon nitride may be less brittle than some conducting ceramic material, such as siliconized silicon carbide (SiSiC). The use of silicon nitride may result in burls that can withstand higher lateral forces and/or are less sensitive to damage, e.g. during manufacture and/or use of the object holder.

In the embodiment shown in Figure 2, the first, second and third insulating layers 18, 20, 24 comprise the same insulating ceramic material. However, it will be appreciated that in other embodiments, at least one of the first, second and third insulating layers may comprise an insulating ceramic material that is different from an insulating ceramic material of at least one other of the first, second and third insulating layers.

A thickness of the first insulating layer 18 may be between about 1 mm and 20 mm. A thickness of the second insulating layer 20 may be between about 0.2 mm and 5 mm. A thickness of the third insulating layer 24 may be between about 5 µm and 1000 µm.

The first conductive layer 16 may comprise an electrically conducting material, such as a metal, metal alloy, a semiconductor material or an electrically conductive ceramic material. The electrically conducting material of the first conductive layer 16 may comprise a volume resistance of less than 1 Ohm-cm, preferably less than 0.1 Ohm·cm, more particularly less than or equal to 10⁻⁶ Ohm·cm. The electrically conducting material of the first conductive layer 16 may comprise a metal nitride, such as titanium nitride, and/or a metal silicide, such as molybdenum silicide. In this embodiment, the electrically conducting material of the first conductive layer 16 comprises doped silicon nitride. The dopant or dopant material may comprise titanium nitride. A volume concentration of the dopant or dopant material in silicon nitride may be between about 1% and 50%. A volume resistance of silicon nitride may depend on the volume concentration of the dopant or dopant material. For example, silicon nitride having a volume concentration of about 35% of titanium nitride may comprise a volume resistance of about 0.6 × 10⁻³ Ohm·cm. It will be appreciated that in other embodiments, the dopant or dopant material may comprise molybdenum silicide. A thickness of the first conductive layer 16 may be between about 20 nm and 2 mm.

The second conductive layer 22 may comprise an electrically conducting material. The electrically conducting material of the second conductive layer 22 may be the same as or different from the electrically conducting material of the first conductive layer 16. For example, the electrically conducting material of the second conductive layer 22 may comprise a metal, a metal alloy, a semiconductor material or an electrically conductive ceramic material. An exemplary electrically conducting material of the second conductive layer 22 may include chromium, silver, gold, platinum, nickel, cobalt, iron, vanadium, tantalum, aluminium, titanium, tungsten, molybdenum, manganese, an alloy of at least two of these materials, or a sequence of layers of two or more of these metals or their alloys, such as an AgCuTi alloy, e.g. Incusil or Ticusil (trade names), a molybdenum manganese alloy, a tin-gold alloy, an eutectic gold-silicon alloy, e.g. Au₉₄Si₆, silicon, metal nitride, such as titanium nitride (TiN, Ti₂N, Ti₃N₄), chromium nitride (CrN), metal carbide, and metal silicide, such as molybdenum silicide (MoSi₂), or silicon-carbide doped with nitrogen (N). The electrically conducting material of the second conductive layer 22 may comprise a volume resistance of less than 1 Ohm·cm, preferably less than 0.1 Ohm·cm, more particularly less than or equal to 10⁻⁶ Ohm·cm. A thickness of the second conductive layer 22 may be between about 5 nm and 100 µm.

The third conductive layer 30 may comprise a material comprising a volume resistance below 1 Ohm·cm. As such, the material of the third conductive layer 30 is referred to herein as an electrically conducting material. In some embodiments, the electrically conducting material of the third conductive layer 30 may comprise a metal nitride, such as chromium nitride. In such embodiments, the electrically conducting material of the third conductive layer 30 may comprise a volume resistance of about 0.8 x 10⁻³ Ohm·cm. In other embodiments, the electrically conducting material of the third conductive layer may comprise doped diamond, such as diamond doped with boron. An exemplary volume concentration of boron in diamond may be between about 100 ppm (0.01%) and 8000 ppm (0.8%). In such other embodiments, the electrically conducting material of the third conductive layer may comprise a volume resistance between about 5 × 10⁻³ Ohm·cm and 200 × 10⁻³ Ohm·cm, such as about 25 × 10⁻³ Ohm·cm. A thickness of the third conductive layer 30 may be between about 5nm and 100 µm.

In use, when a voltage is applied to the second conductive layer 22, e.g. by the voltage source, a potential difference between the object holder WH and the object W is generated. This will give rise to the electrostatic clamping effect, thereby clamping the object W to the object holder WH, e.g. the object table WT. The voltage applied to the second conductive layer 22 may be in the region of about 1kV to 8kV, e.g. to generate a sufficient clamping force. The first conductive layer 16 may be connected to ground potential. As the first and third conductive layers 16, 30 are electrically connected, the burls 26, e.g. the object receiving surfaces 28 thereof, are connected to ground potential, thereby shielding the burls 26 from an electric field generated between the object holder WH and the object W.

Figure 3 schematically depicts in cross section a part of another exemplary object holder WH for use in the lithographic apparatus LA shown in Figure 1. The object holder WH shown in Figure 3 is similar to the object holder WH described above in relation to Figure 2. As such, any features described in relation to the object holder WH shown in Figure 2 may also apply to the object holder WH shown in Figure 3. In the following only differences will be described.

In the embodiment shown in Figure 3, the first and second insulating layers 18, 20 comprise a first insulating ceramic material. The third insulating layer 24 comprises a second insulating ceramic material that is different from the first insulating ceramic material. In this embodiment, the first insulating ceramic material comprises silicon nitride (SiN) and the second insulating ceramic material comprises aluminium oxide (Al₂O₃). It may be desirable to use aluminium oxide as the second ceramic material due to aluminium oxide having a relative dielectric constant of about 8 and a volume resistance larger than 1018 Ohm cm. As can be seen from Figure 3, each burl 26 comprises the first and second insulating ceramic materials.

In the embodiment shown in Figure 3, the recess 34 may extend through the second conductive layer 22. The recess 34 may additionally extend through the second and third insulating layers 20, 24, e.g. so as to expose at least a part of the first conductive layer 16. The burls 26 may be considered as extending from the first conductive layer 16. The third conductive layer 30 may be provided on each burl 26 so as to extend from the object receiving surface 28 into the recess 34 to the first conductive layer 16, thereby electrically connecting the object receiving surface 28 of each burl to the first conductive layer 16. Each portion 32 may comprise the second conductive layer 20 and the second and third insulating layers 20, 24.

Figure 4 schematically depicts in cross section a part of another exemplary object holder WH for use in the lithographic apparatus shown in Figure 1. The object holder WH shown in Figure 4 is similar to the object holder WH described above in relation to Figures 2 and 3. As such, any features described in relation to the object holder WH shown in Figures 2 and 3 may also apply to the object holder WH shown in Figure 4. In the following only differences will be described.

In the embodiment shown in Figure 4, the object holder WH comprises an electrostatic clamp and a Johnsen-Rahbek clamp. In this embodiment, the layer of resistive or conductive material is referred to as a resistive layer 30. For example, the electrostatic clamping force may be generated by the portions 32. The object holder WH may be configured such that the Johnsen-Rahbek clamping force is generated by the resistive layer 30 on the burls 26. For example, the first conductive layer 16 may be configured as an electrode for connecting the Johnsen-Rahbek clamp to a voltage source (not shown in Figure 4). A voltage applied to the first conductive layer 16 may be less than the voltage applied to the second conductive layer 22 described above. For example, the voltage applied to the first conductive layer 16 may be less than 250V. The voltage applied to the first conductive layer 16 may be less than 10V, e.g. as little as 3V. The resistive layer 30 comprises a material comprising a volume resistance larger than 1 Ohm cm. As such, the material of the resistive layer 30 is referred to as a resistive material. In this embodiment, the resistive material may be selected to comprise a volume resistance that allows for the Johnsen-Rahbek effect. For example, the resistive material may comprise a volume resistance of about 10¹¹ Ohm cm. The resistive material may comprise at least one of aluminium nitride and/or lithium aluminoasilicate.

In use, when the first conductive layer 16 is connected to the voltage source, charge carriers may migrate to an upper surface of the resistive layer 30 on each burl 26. The upper surface of the resistive layer 30 may be rough. As such, there may be peaks and troughs on the upper surface of the resistive layer 30. Charge carriers that are located on the peaks may flow into the object W. Charge carriers that are located in the troughs may remain in the troughs and give rise to the Johnsen-Rahbek effect, thereby clamping the object W to the object holder WH, e.g. the object table WT. For example, a distance between the object W and the troughs may be in the region of about 1 µm. The first conductive layer 16, the resistive layer 30 and the burls 26 form the Johnsen-Rahbeck clamp.

As described above, in use, when a voltage is applied to the second conductive layer 22, e.g. by the voltage source, a potential difference between the object holder WH and the object W is generated. This will give rise to the electrostatic clamping effect, thereby clamping the object W to the object holder WH, e.g. the object table WT. The second insulating layer 20, the second conductive layer 22 and the third insulating layer 24 form the electrostatic clamp.

By clamping the object W using an object holder comprising the electrostatic clamp and the Johnsen-Rahbek clamp, as described herein, slippage of the object W relative to the burls 26 may be reduced or prevented. For example, lithographic exposure of the object may result in heat being generated in the object. In examples where only electrostatic clamping force is applied to the object, the generated heat may cause the object to expand locally, which may cause slippage of the object over the burls, e.g. during lithographic patterning. The additional clamping force applied by the Johnsen-Rahbek clamp may prevent or reduce the expansion of the object and thereby the slippage of the object over the burls. However, the Johnsen-Rahbek clamp may take a longer time to establish a clamping force relative to the electrostatic clamp. Additionally, the Johnsen-Rahbek clamp may be more affected by particulate contamination relative to the electrostatic clamp. For example, when a particle with a thickness larger than the distance between the object W and the troughs of the upper surface on each burl is located between the upper surface of a burl and the object W, a clamping force of the Johnsen-Rahbek at the position of the particle may be decreased or absent. In contrast, due to the small size of the particle relative to a distance between the object W and an upper surface of the electrostatic clamp, the presence of the particle on the upper surface of the electrostatic clamp may have little or no effect on the clamping force of the electrostatic clamp. As such, in some applications, it may be desirable to provide the object holder as an electrostatic clamp only while it may be desirable to provide the object holder as an electrostatic clamp and a Johnsen-Rahbek clamp for other applications.

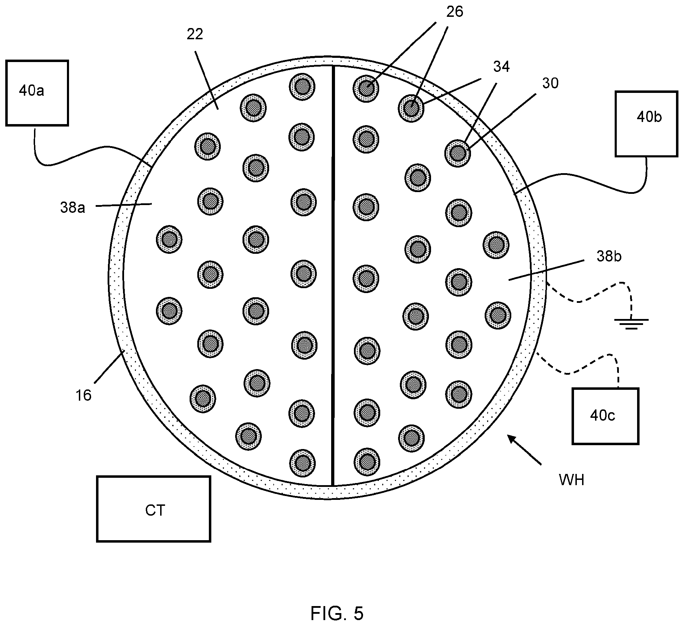

Figure 5 schematically depicts a plan view of an exemplary object holder WH for use in the lithographic apparatus shown in Figure 1. Any of the features described in relation to the object holder WH shown in any of Figures 2 to 4 may also apply to the object holder shown in Figure 5. The third insulating layer has been omitted from Figure 5 for clarity purposes. In addition, the first conductive layer 16 is shown as having a larger diameter than the second conductive layer 20 for sake of clarity. It will be appreciated that a diameter of each of the first and second conductive layers 16, 20 may be the same, similar or different. The object holder WH may have a circular shape. A diameter of the object holder WH may be in the region of about 300 mm to 400 mm, such as 350 mm. The object holder WH may define an object support area 36. The object support area may have a diameter in the region of 200 mm to 350 mm, such as 300 mm. It will be appreciated that the dimensions of the object holder disclosed herein are merely exemplary dimensions and that in other embodiments other dimensions of the object holder may be used.

The object holder WH may comprise a first part 38a and a second part 38b. The first and second parts 38a, 38b of the may each be generally semi-circular. Each of the first and second parts 38a, 38b of the object holder WH comprise the second conductive layer 22, as described above. The second conductive layer 22 of the first part 38a of the object holder WH may comprise or define one of the two electrodes described above. The second conductive layer 22 of the second part 38b of the object holder WH may comprise or define the other one of the two electrodes described above.

A first voltage source 40a may be connected to the first part 38a of the object holder WH. The first voltage source 40a may be configured to apply a voltage to the second conductive layer 22 of the first part 38a of the object holder WH. A second voltage source 40b may be connected to the second part 38b of the object holder WH. The second voltage source 40b may be configured to apply a voltage to the second conductive layer 22 of the second part 38b of the object holder WH. The first and second voltage sources 40a, 40b may be configured to apply voltages of opposite pluralities to the first and second parts 38a, 38b of the object holder WH. The first and second parts 38a, 38b of the object holder WH may be arranged to be adjacent to each other. However, as described above, the two electrodes are electrically isolated from each other.

As described above, when the object holder WH comprises an electrostatic clamp, the first conductive layer 16 may be connected to ground potential. This is indicated by a dashed line in Figure 5. When the object holder WH comprises an electrostatic clamp and a Johnsen-Rahbek clamp, a third voltage source 40c may be connected to the first conductive layer 16. This connection is indicated by the dashed line in Figure 5. The first, second and/or third voltage sources 40a, 40b, 40c may be controlled by a controller CT. It will be appreciated that in other embodiments, less than three voltage sources may be used. For example, the first and second parts of the object holder may be connected to a single voltage source.

As can be seen in Figure 5 each burl 26 is surrounded by a respective annular recess 34. The third conductive layer or resistive layer 30 can be seen in each recess 34 around each respective burl 26. As described above, the second and third insulating layers 20, 24 may be provided so as to electrically isolate the second conductive layer 22 from the burls 26. This may allow for the electrostatic clamp and the Johnsen-Rahbek clamp to be operated independently of each other.

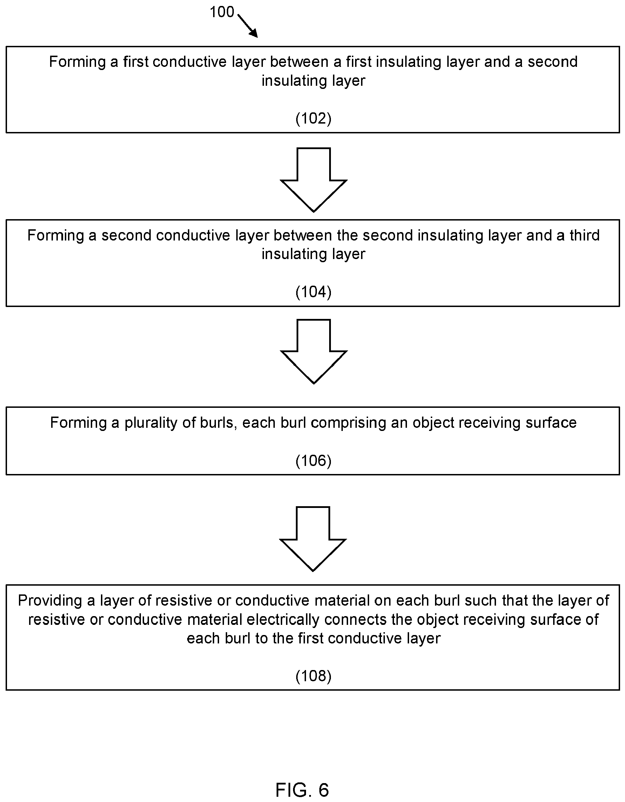

Figure 6 depicts an exemplary flow diagram outlining the steps of a method 100 of manufacturing an object holder configured to support an object. The object holder may comprise any of the feature of the exemplary object holders WH described above.

In step 102, the method 100 comprises forming a first conductive layer between a first insulating layer and a second insulating layer. The method 100 may comprise providing a first material for forming the first conductive layer. The first material may comprise a conductive ceramic material. For example, the first material may comprise doped silicon nitride. In this embodiment, silicon nitride is doped with titanium nitride. In other embodiments, the first material may comprise silicon nitride doped with molybdenum silicide. The first material may be provided in the form of a ceramic suspension. It will be appreciated that in other embodiments, the first material may be provided in the form of a powder or the like. The method may comprise providing a second material for forming the first and second insulating layers. The second material may comprise an insulating ceramic material, such as silicon nitride. The second material may be provided in the form of a ceramic suspension. The ceramic suspension of the first and/or second materials may also be referred to as a green state ceramic. The first and/or second materials may be soft and/or deformable to facilitate shaping of the first and/or second materials, for example into a selected or desired shape and/or to allow for printing, e.g. 3D printing, of the first and/or second materials. It will be appreciated that in other embodiments second material may be provided in the form of a powder. The first material may be arranged between a first layer of the second material and a second layer of the second material. Expressed differently the first material may be arranged as an interlayer. The method 100 may comprise using a sintering and/or hot press process to form the first and second insulating layers and the first conductive layer between the first and second insulating layers. The sintering and/or hot press process may comprise heating the first and second materials at a temperature between about 1500° C to 1700° C.

In step 104, the method 100 comprises forming or providing a second conductive layer between the second insulating layer and a third insulating layer. The method 100 may comprise providing a third material for forming the second conductive layer on at least one of the second and third insulating layers. The method 100 may comprise connecting the second and third insulating layers together such that the second conductive layer is formed between the second and third insulating layers. The second and third insulating layers may be connected together using a bonding process, e.g. a diffusion bonding process. A temperature and/or pressure for bonding the second and third insulating layers together may be selected such that the second and third insulating layers do not melt or soften, no deformation occurs and diffusion of the third material between the second and third insulating layers occurs. The temperature may be in a range from 270° C to 2000° C, such as in a range from 1100° C to 1500° C. The pressure, e.g. pressing pressure, may be in a range from 50 bar to 2000 bar, such as a range from 150 bar to 500 bar. The third material may be selected so that the second conductive layer comprises a metal such as chromium, silver, gold, platinum, nickel, cobalt, iron, vanadium, tantalum, aluminium, titanium, tungsten, molybdenum, manganese, an alloy of at least two of these materials, or a sequence of layers of two or more of these metals or their alloys, such as an AgCuTi alloy, e.g. Incusil or Ticusil (trade names), a molybdenum manganese alloy, a tin-gold alloy, an eutectic gold-silicon alloy, e.g. Au₉₄Si₆, silicon, metal nitride, such as titanium nitride (TiN, Ti₂N, Ti₃N₄), chromium nitride (CrN), metal carbide, and metal silicide, such as molybdenum silicide (MoSi₂), or silicon-carbide doped with nitrogen (N).

In step 106, the method 100 comprises forming a plurality of burls. The burls may be formed using a material removal process, such as electrical discharge machining (EDM), etching, machining, laser ablation and/or the like. Each of the burls comprises an object receiving surface. The burls may be formed such that each burl is surrounded by the recess, as described above.

In step 108, the method 100 comprises providing a layer of resistive or conductive material on each burl of the plurality of burls such that the layer of resistive or conductive material electrically connects the object receiving surface of each burl of the plurality of burls to the first conductive layer. The layer of resistive or conductive material may be deposited on each burls using a deposition process, such as vacuum deposition, chemical vapour deposition or the like.

It will be appreciated that the first material may comprise any of the features and/or properties described in relation to the first conductive layer 16. The second material may comprise any of the features and/or properties described in relation to the first and/or second insulating layer 18, 20. The third material may comprise any of the features and/or properties described in relation to the second conductive layer 22.

It will be appreciated that one or more of the first and second conductive layers and the layer of resistive or conductive material may comprise a pattern or shape. As such, in some embodiments, the method may comprise using a mask to apply a desired shape or pattern of one or more of the first and second conductive layers and the layer of resistive or conductive material on at least one of the first, second and third insulating layer and the burls. In some embodiments, the method may comprise using a lithographic process for applying a pattern or shape on one or more of the first and second conductive layers and the layer of resistive or conductive material. For example, one or more of the first and second conductive layers and the layer of resistive or conductive material may be provided on at least one of the first, second and third insulating layers and the burls, as described above. A layer of resist may be deposited on one or more of the first and second conductive layers and the layer of resistive or conductive material. The layer of resist may be exposed to radiation and developed with the desired pattern or shape. One or more etching processes may be used to form the pattern or shape in one or more of the first and second conductive layers and the layer of resistive or conductive material. For example, any of the above steps may be used to provide the layer of resistive or conductive material on each burl or a part thereof.

It will appreciated that the method may comprise one or more pre-processing steps, which may comprise a polishing step. For example, a surface at least one or each of the second and third insulating layers may be polished prior to the provision of the second conductive layers thereon, as described above.

It will appreciated that the method may comprise one or more post-processing steps, which may comprise one or more thinning steps of one or more of the first, second and third insulating layers.

The term "lateral direction" may be understood as a direction parallel to the first, second and/or third insulating layers. The term "longitudinal direction" may be understood as a direction perpendicular to the lateral direction.

It will be appreciated that the first, second and third insulating layer, the first and second layers, the layer of resistive or conductive material and the burls, as described above, may be provided on either side of the object holder WH. A first side of the object holder may thus be configured to clamp the object holder WH to the object table WT, while a second side of the object table is configured to support the object W, as described above.

It will be understood that references to a plurality of features may be interchangeably used with references to singular forms of those features, such as for example "at least one" and/or "each". Singular forms of a feature, such as for example "at least one" or "each," may be used interchangeably.

Although embodiments of the invention have been described in connection with a substrate, a substrate holder and a substrate table, in other embodiments the invention may be used to clamp a mask MA (or other patterning device) to a support structure MT of a lithographic apparatus (see Figure 1), or to clamp some other object.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions. An object holder according to an embodiment of the invention may form part of a lithographic tool.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. An object holder configured to support an object, the object holder comprising:
a first conductive layer provided between a first insulating layer and a second insulating layer;
a second conductive layer provided between the second insulating layer and a third insulating layer;
a plurality of burls, each burl of the plurality of burls comprising an object receiving surface; and
a layer of resistive or conductive material provided on at least one or each burl of the plurality of burls such that the layer of resistive or conductive material electrically connects the object receiving surface of the at least one or each burl of the plurality of burls to the first conductive layer.

2. The object holder of claim 1, wherein the at least one or each burl of the plurality of burls is surrounded by an annular recess, the recess extending through the first and second conductive layers, the second and third insulating layers and at least partially into the first insulating layer.

3. The object holder of claim 2, wherein the layer of resistive or conductive material is provided on the at least one or each burl of the plurality of burls so as to extend from the object receiving surface of the at least one or each burl of the plurality of burls into the recess, along a part of the first insulating layer and to the first conductive layer.

4. The object holder of claim 1 or 2, wherein at least one or each burl of the plurality of burls is surrounded by an annular recess, the recess extending through the second conductive layer and the second and third insulating layers so as to expose at least a part of the first conductive layer.

5. The object holder of claim 4, wherein the layer of resistive or conductive material is provided on the at least one or each burl of the plurality of burls so as to extend from the object receiving surface of the at least one or each burl of the plurality of burls into the recess and to the first conductive layer.

6. The object holder of any preceding claim, wherein the object holder comprises at least one of:
an electrostatic clamp; or
an electrostatic clamp and a Johnsen-Rahbek clamp.

7. The object holder of claim 6, wherein the first conductive layer is configured as at least one of:
an electrode for connecting the electrostatic clamp to ground potential; or
an electrode for connecting the Johnsen-Rahbek clamp to a voltage source.

8. The object holder of claim 7, wherein the second conductive layer is configured as two or more electrodes for connecting the electrostatic clamp to a voltage source, the two or more electrodes being electrically isolated from each other.

9. The object holder of any preceding claim, wherein the second and third insulating layers are arranged to electrically isolate the second conductive layer from the first conductive layer and the layer of resistive or conductive material.

10. The object holder of any preceding claim, wherein the first, second and third insulating layer comprise an insulating ceramic material, the insulating ceramic material comprising at least one of: silicon nitride and aluminium oxide.

11. The object holder of any preceding claim, wherein the first conductive layer comprises an electrically conducting material, the electrically conducting material comprising at least one of: titanium nitride and molybdenum silicide.

12. The object holder of any preceding claim, wherein the layer of resistive or conductive material comprises a resistive material, the resistive material comprising at least one of:
a volume resistance of about 10¹¹ Ohm cm;
aluminium nitride; and
lithium aluminoasilicate.

13. The object holder of any one of claims 1 to 11, wherein the layer of resistive or conductive material comprises an electrically conducting material, the electrically conducting material comprising at least one of:
a volume resistance of less than 1 Ohm·cm;
chromium nitride;
and doped diamond.

14. A lithographic tool comprising an object holder according to any of claims 1-13.

15. A method of manufacturing an object holder configured to support an object, the method comprising:
forming a first conductive layer between a first insulating layer and a second insulating layer;
forming a second conductive layer between the second insulating layer and a third insulating layer;
forming a plurality of burls, each burl of the plurality of burls comprising an object receiving surface; and
providing a layer of resistive or conductive material on at least one or each burl of the plurality of burls such that the layer of resistive or conductive material electrically connects the object receiving surface of the at least one or each burl of the plurality of burls to the first conductive layer.
